# EUROPEAN PATENT APPLICATION

(11) **EP 1 976 346 A1**
(43) Date of publication of application: **01.10.2008**
(21) Application number: 07300913.6
(22) Date of filing: 30.03.2007
(51) Int. Cl.: H05H 1/46, H01J 37/32

(54) **Apparatus for generating a plasma**

(71) Applicant: ECOLE POLYTECHNIQUE, 91120 Palaiseau (FR); Centre National de la Recherche Scientifique, 75794 Paris Cedex 16 (FR)
(72) Inventor: Bulkin, Pavel, 91140, VILLEBON SUR YVETTE (FR); Drevillon, Bernard, 92140, CLAMART (FR)
(74) Representative: Michelet, Alain

(57) **Abstract**

The present invention concerns an apparatus for generating a plasma comprising a vacuum chamber (1) comprising a wall (2) and a plasma source (5) comprising one or more devices for exciting the plasma (6), and means for generating a constant magnetic field around the plasma in order to couple microwave energy into plasma at electron cyclotron resonance, each of said devices for exciting the plasma (6) comprising a coaxial microwave connector (7) able to be connected to a microwave energy source and a loop antenna (9) able to emit a microwave energy for exciting the plasma. According to the invention, the loop antenna (9) of the one or more devices for exciting the plasma (6) is positioned inside the vacuum chamber (1) in order to be in contact with the plasma and the means for generating a constant magnetic field comprises at least two magnetic dipoles (10) placed on the wall of the vacuum chamber (1), each of said one or more devices for exciting the plasma (6) having said two magnetic dipoles (10) placed on both sides.

## Description

Current invention is related to an apparatus for generating a plasma. It has numerous applications in the fields of surface treatment, deposition or etching of materials.

Plasma is widely used in the modern technology for applications ranging from welding to medical sterilization through space propulsion. One important area of application is thin film deposition technology for microelectronics, optics, protective coatings and photovoltaics. It benefits from the ability of plasma to drive chemical reactions at low temperatures and high rates. This is possible because non-thermal plasma is a highly non-equilibrium state of the matter, with electrons having much higher energies, than ions and neutrals and thus is able to produce ionization and dissociation of the background gas. The electrons are gaining their energy from electric field and transferring it to heavy particles via inelastic collisions. Thus source of electric energy is required to produce plasma. It can be direct current (DC) or alternating current (AC), in latter case, depending on frequency, low frequency (LF), radiofrequency (RF) or microwave (MW).

Most important qualities of plasma sources are the working range of pressures and plasma density they can create, the stability of operation, ability to work with corrosive gases and uniformity area. Plasma density and pressure of operation have direct impact on processing rate (either deposition or etch), while area of uniformity determines size of the substrates that can be treated. For large area plasma processing the choice of plasma source is currently very limited. For etching it is either capacitively coupled RF plasma (RF CCP) or Matrix (sometimes called Multi-dipolar) Distributed Electron Cyclotron Resonance. For deposition it is those two and magnetron sputtering. The two plasma technologies, RF CCP and magnetron, are the only used commercially for large area (more than 1m² areas). However, RF CCP and magnetron have serious limitation on the processing rate. For the deposition of amorphous silicon for photovoltaic applications, for example, rates of about 0.2 to 0.3 nm per second are usually reported. Major technological breakthrough will be required for high-rate (more than 2 nm/sec) deposition. As much as amorphous silicon deposition, silica, silicon nitride and silicon oxynitrides for applications in protective and optical coatings require highest deposition rate possible, without degrading the film quality. And as those depositions required to be performed on larger and larger surfaces and, sometimes, in roll-to-roll setups, there is urgent need in the development of high-density plasma source that is scalable and can provide high precursor fluxes.

There are two approaches for creation of large area uniform plasma source.

The first approach is to use source generating single large area plasma. In RF plasma the plasma sheath above the substrate plays this role as transfer of the energy from electric field to the electrons takes place in this thin layer above substrate surface. However, even if substrate and its electrode are completely homogeneous, and gas composition perfectly uniform along its surface, there are still problems associated with finite wavelength of RF wave, problems which are worsening with the scaling up of the treatment area.

The second approach calls for a number of point plasma sources arranged in such a way as to allow diffusion to homogenize the precursor fluxes onto the surface. This approach is intrinsically more scalable, as it allows increasing the treatment area just by increasing the number of individual sources in two directions. This approach is also most suitable for high-density low-pressure plasma sources.

Three generic types of high-density sources exist now: transformer (or inductively) coupled plasma (TCP, sometimes called ICP), helicon and electron cyclotron resonance (ECR). The two first rely on standard RF power supplies (although helicon utilize magnetic field of about 100 Gauss), while ECR is based on shorter microwave electromagnetic waves with frequencies above 900 MHz and strong magnetic fields. All those high-density sources operate at pressures below 60 mTorr and provide plasma densities in the range 10¹¹ to 10¹² cm⁻³. They all have high ionization rate and dissociation efficiency. As far as their scale up potential is concerned, helicons and TCP/ICP sources due to their design principles have very little scale-up potential. It is not the case, however, for ECR sources.

The ECR plasma sources are based on the well-known electron cyclotron resonance effect. That means they operate in the condition when frequency of electric field is matched by the static magnetic field in such a way, that electrons can continuously gain energy (provided there are no collisions) during both half-periods of the electric field oscillation. It is the Larmor force, that turns the electrons just in time to be accelerated by the second half of sine wave of alternating electric field, but only if magnetic field satisfy the equation B=2π.(mₑ/e).f₀, where mₑ is a mass of electron, e its charge and f₀ is a frequency of the electric field in Hz. At the most common microwave frequency of 2.45 GHz this static magnetic field shall be equal 875 Gauss. Resonance provides continuous increase of electron energy until it collides with neutral, either to be elastically scattered or to excite or ionize it.

To create necessary magnetic field either Helmholz coils or permanent magnets can be used. In the first case the design is straightforward and usually features waveguide introduction of microwaves with coils surrounding the source or reactor body. The very presence of those coils limits the area of uniform plasma to about 50 cm in diameter. With further increase, the size of the coils will become prohibitively large and may require superconductive wires. While, it is possible to use superconductors for research applications, it is not economically justified for industrial implementation. There is also ever-growing radial non-uniformity of magnetic field with enlargement of the coils diameter. Permanent magnets, on the other hand, give much more flexibility to design the sources suitable for large area distributed applications. Their only drawback is that magnetic field, while very high on the surface, decline rapidly with distance due to divergence of magnetic field lines. However, by the careful choice of the permanent magnets positions one can successfully use them for creating ECR zones. Different materials are used in permanent magnets. In initial DECR system ferrite magnets were used along vertical antennas. Ferrite magnets reach Br values of residual magnetic flux density (that is maximal magnetic flux that magnets can create) of 3900 Gauss. Most strongest, however, are rare-earth based. They are either SmCo alloys or NeFeB alloys. They typically have Br of 10500 Gauss and 12800 Gauss, respectively, and thus are more advantageous to use in plasma sources.

Second important characteristic of an ECR plasma source is the way of introducing electromagnetic energy with microwave frequency into the discharge. The transport of microwaves from the generator to the source can be done either by the waveguide (TE or TM modes) or coaxial line (TEM mode). Then, the energy needs to be transferred into the source body. Several ways were suggested. Divergent ECR sources all have dielectric window, separating parts of waveguide that are on air from the-low pressure part, which can be considered also as a waveguide or resonant cavity. Electromagnetic wave, thus, is traveling across the window and generates plasma in the low-pressure volume of the source, surrounded by electromagnetic coils. This, however, induce problems when deposition of conductive material need to be performed. Deposition of such material on window will reduce and eventually stop transmission of microwaves through it. Because of this, divergent systems are used only for etching and dielectric deposition. The second possibility is to use coaxial vacuum feedthrough to pass the microwaves into the vacuum vessel. After that, the wave can be longed into the source by an antenna. There are many types of antennas used in electromagnetic wave transmission, with majority originating from radio communication engineering, however in plasma sources usually probe antennas, horn antennas and loop antennas were suggested as for example in US Patent 4,906,900. Depending on antenna type, the properties of the wave, excited in the source volume will differ. Antenna can also be used to excite the electromagnetic wave in the source from outside of vacuum volume, using dielectric separation between the vacuum and air sides. In this case, however, all limitations for conductive films deposition will be identical to the waveguide-window type of systems.

Systems based on the ECR concept are already known. Most prominent ones are distributed ECR plasma based on permanent magnets integrated into probe antennas as described in US Patent 6,407,359. Another source, US Patent 7,081,710 B2 is disclosing an ECR plasma apparatus based on microwave horn antenna. Generally, all known sources have clearly difficulties of scale up to treat large surfaces, except of MDECR and horn-type sources. Both of them, however, share considerable complexity and are not easy to industrialize and maintain. Among serious drawbacks are relatively long applicator protruding into the plasma processing volume, complicated system of water cooling and problematic cleaning after long deposition runs due to considerable area with complex shape.

The current invention is based on the ECR concept with microwave injected by antenna(s) into the processing volume in the vicinity of high magnetic field(s), created by permanent magnets. It allows the formation of high-density plasma in the condition of electron cyclotron resonance using microwave energy and permanent magnets. This is obtained thanks to an elementary plasma source based on ECR effect and a loop antenna. A loop antenna, which may be of adjustable length, is connected on one side to coaxial line supplying microwave power from a microwave generator via coaxial vacuum feedthrough and on another side is grounded by welding, soldering or screwing either to reactor wall or to the grounded part of the vacuum flange carrying coaxial vacuum feedthrough. There is no limitation on the shape of the antenna loop or it length even if it is preferable that it is adapted to the operating microwave frequency: it can be classical circular loop, frame-type, triangle or any other shape. Loop starts at the place when central coaxial conductor leaves coaxial channel and has its further end grounded either directly on the reactor wall or on the part carrying vacuum feedthrough. It has to be noted that ECR is the most efficient when electrical field vector of microwave field is perpendicular to magnetic field lines. Loop antenna emits magnetic wave mainly in the plane perpendicular to loop plane with electric wave component in the loop plane. Thus, it is easy to arrange magnets on the outside of the reactor wall. For example, SmCo₅ magnets of different polarity are placed outside of vacuum chamber parallel to each other on both sides of coaxial connector, providing ECR surface on a certain distance from the chamber wall thus creating plasma sheet parallel to the wall of reactor and pushing it, due to the gradient of magnetic field, towards treated surface.

More precisely, the current invention is about an apparatus for generating a plasma comprising:
- a vacuum chamber comprising a wall having an outer surface and an inner surface,
- a plasma source comprising:
   o one or more devices for exciting the plasma, each of said devices for exciting the plasma comprising a coaxial microwave connector able to be connected to a microwave energy source placed outside of vacuum chamber, coaxial vacuum feedthrough and a loop antenna able to emit a microwave energy for exciting the plasma and placed inside vacuum chamber,
   o means for generating a constant magnetic field inside the plasma volume in order to couple microwave energy into plasma at electron cyclotron resonance.

According to the invention:
- the loop antenna of the one or more devices for exciting the plasma is positioned inside the vacuum chamber in order to be in contact with the plasma, and
- the means for generating a constant magnetic field comprises at least two magnetic dipoles placed on the wall of the vacuum chamber, each of said one or more devices for exciting the plasma having said two magnetic dipoles placed on both sides.

According to various embodiments, the present invention also concerns the characteristics below, considered individually or in all their technical possible combinations:
- the at least two magnetic dipoles are placed on the outer wall surface of the vacuum chamber,
- the at least two magnetic dipoles are permanent magnets having a quadrilateral shape, an upper surface and a lower surface, said upper surface being parallel to said lower surface, and said lower surface of the at least two permanent magnets being placed on the outer wall surface of the vacuum chamber,
- the plasma source comprises one or more devices for exciting the plasma,
- the means for generating a constant magnetic field comprises only two magnetic dipoles placed on both sides of said one or more devices for exciting the plasma,
- the plasma source comprises n assemblies of devices for exciting the plasma, n being superior or equal to 2, each of the n assemblies of devices for exciting the plasma comprising one or more devices for exciting the plasma,
- the means for generating a constant magnetic field comprises n+1 magnetic dipoles, each assemblies of devices for exciting the plasma having two magnetic dipoles placed on both sides, forming a one or two-dimensional array of devices for exciting the plasma wherein the n assemblies of devices for exciting the plasma are alternated with the n+1 magnetic dipoles,
- the number of devices for exciting the plasma is modulated in each lines of devices for exciting the plasma,
- the lower surfaces of the permanent magnets of the means for generating a constant magnetic field are coplanar,
- the lower surfaces of the two permanent magnets of the means for generating a constant magnetic field are inclined with respect to each other, according to an angle (α),
- the wall of the vacuum chamber comprises a shaped part including a first surface whereon the one or more devices for exciting the plasma are placed, and two second surfaces inclined with respect to the first surface, each second surface supporting one of the two permanent magnets and being linked to the first surface,
- the coaxial microwave connector comprises an outer conductor and the loop antenna comprises a first end and a second end, said first end being connected electrically to the central conductor of the coaxial microwave connector and said second end being connected electrically indirectly to the outer conductor of the coaxial microwave connector, by grounding on the inner surface of the wall of the vacuum chamber,
- the coaxial microwave connector is a bilateral coaxial microwave connector, the first end of the loop antenna being connected electrically to the central conductor and the second end of the loop antenna being connected electrically directly to the outer conductor of the coaxial microwave connector, inside the vacuum chamber.

Thanks to the invention allowing the creation of high and uniform fluxes of excited precursors onto the surfaces of treated substrate from high-density plasma sources, the thin film deposition technology also benefits of low maintenance and scalability.

Other technical advantages are: the absence of cooling line inside the vacuum chamber; the relatively small additional area exposed to plasma in comparison with the wall area; the possibility to decrease processing volume (due to the relatively small size of the antenna loop) and thus to increase volume power density; the simplicity of the microwave circuitry; and the use of standard components (except for the loop antenna) in the source assembly..

As a consequence, the apparatus of the invention which allows the creation of high-density plasma, has direct implication towards high-rate PECVD of silicon based thin films (a-Si:H, SiO₂. Si₃N₄, oxynitrides, Ge-doped silica, etc.) and plasma etching. Areas of particular interest being the deposition of i-layers (undoped amorphous silicon layers) in solar cell structures and optical, functional, protective and scratch-resistant coatings.

The description of the invention is illustrated by the following drawings in which:
Figure 1 is a cross-section view of a vacuum chamber with a plasma source according to one embodiment of the invention,
Figure 2 is a perspective cross-section view of a part of a vacuum chamber with a plasma source according to the invention, the loop antenna being omitted for simplification purpose,
Figure 3 is a cross-section view of another embodiment of a part of a vacuum chamber with a plasma source according to the invention,
Figure 4 is a perspective view of a part of a vacuum chamber with multiple plasma sources according to the invention,
Figure 5 is a lateral view of a device for exciting the plasma with a loop antenna of the rhombic loop type, and
Figure 6 is a lateral view of a device for exciting the plasma with a loop antenna of the frame loop type,
Figure 7 is a lateral view of a bilateral coaxial microwave connector 7.

As compared to known ECR sources, the current invention uses a combination of loop antennas (radiating elements) placed inside of a vacuum (plasma) volume with permanent magnets placed either outside of the reactor or inside (in the latter case, cooling of the magnets could be needed if the magnetic properties of the magnets are reduced by heat) and possibility to combine several loop sources to form linear as well large area sources. Consequently, the antenna being inside the plasma volume, it is in galvanic contact with plasma, which helps in extending the range of operating conditions of the plasma (pressure and power). The source may not necessarily possess a resonant cavity structure and can be used together with radiofrequency-induced DC bias applied to the substrate surface in order to precisely control the ion energy and fluxes onto the substrate.

Despite not having resonant cavity structure, minimal microwave power required to sustain the discharge is about 20 watts per antenna at 5 mTorr pressure of air as measured before coaxial impedance matcher directly connected to the vacuum feedthrough coaxial (for example N-type) connector. Minimal pressure within the vacuum vessel will be limited to that of provided by pumping system (given configuration of equipment, gas supply, existence of loadlock, etc....). Operational pressure range of the source as an ECR source is at least from 0.2 mTorr to 20 mTorr, being limited from above by the increasing collisions frequency preventing ECR effect to take place and from below by the insufficient density of the gas to sustain the ionization.

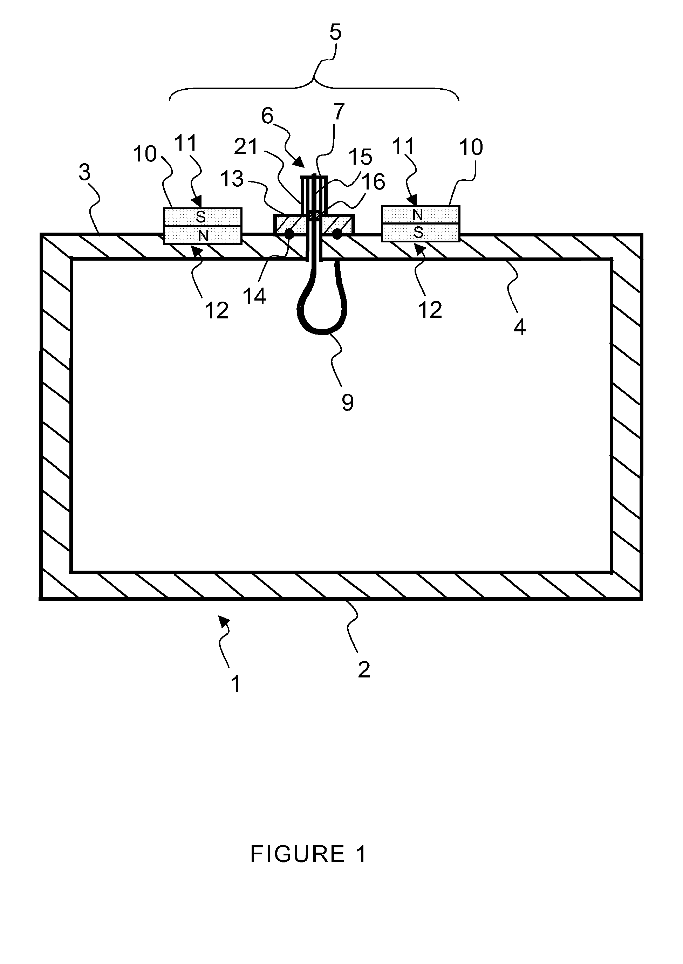

In the Figure 1, the microwave energy produced by an external generator (not represented) is delivered by a coaxial line (not represented) to a microwave coaxial connector 7 of a device 6 for exciting the plasma in a vacuum chamber 1 made of a wall 2 having an outer surface 3 and an inner surface 4. In another embodiment (not represented) the external generator is directly connected to the coaxial microwave connector 7 of the device 6 for exciting the plasma. In order to accommodate the impedance of the antenna loop and reduce the reflected power, impedance matching devices may be connected between coaxial line delivering microwave power (or the generator if no coaxial line) and the coaxial microwave connector 7 of the device 6 for exciting the plasma having an antenna loop 9. For example, the loop antenna 9 may be 3 mm thick copper wire with full length of 13 cm.

The coaxial microwave connector 7 comprises a central conductor 15 which is supported by (and passes through) a vacuum-tight dielectric separator 16, which isolate interior of the vacuum chamber 1 from the outside environment. The vacuum-tight dielectric separator 16 may be made with ceramic material. The device 6 for exciting the plasma is located in relation to an aperture in the wall 2 and the coaxial microwave connector 7 is mounted on a flange 13 which is attached to the wall 2. Vacuum seal 14, which can be elastomer or metal seal, means to provide the tightness of the connection between the wall 2 and the device 6 for exciting the plasma. The coaxial microwave connector 7 comprises an outer conductor 21 and can comprise an insulating part 23 between the outer conductor 21 and the central conductor 15. The loop antenna 9 comprises a first end 19 and a second end 20.

Inside of the vacuum chamber, the loop antenna 9 is connected electrically to the central conductor 15 of the coaxial microwave connector 7 and tightly fixed, preferably, screwed, soldered or welded there. The first end 19 of the loop antenna 9 is connected electrically to the central conductor 15 of the coaxial microwave connector 7.

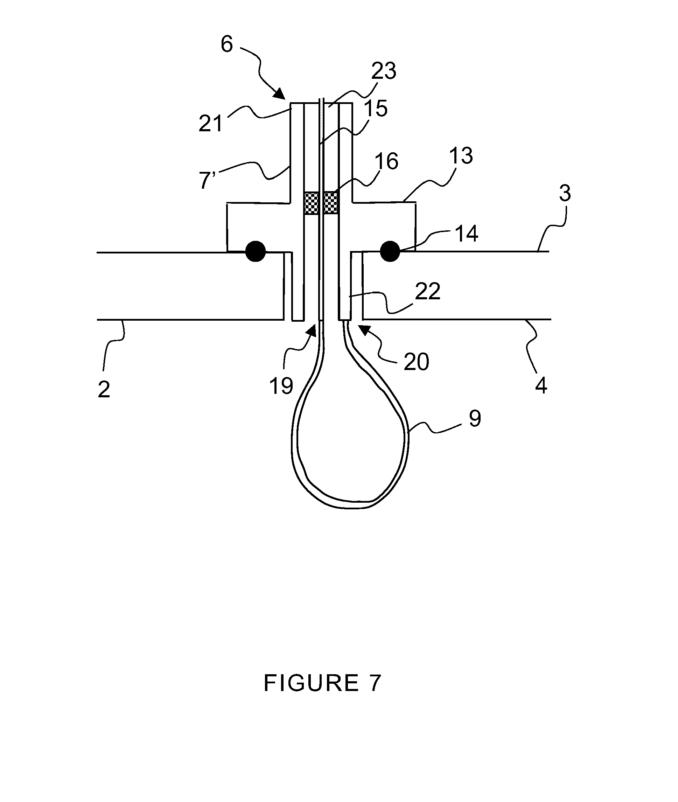

The second end 20 of the loop antenna 9 may be connected electrically (directly (Figure 7) or indirectly (Figure 1)) to the outer conductor 21 of the coaxial microwave connector 7, inside the vacuum chamber 1, in order to loop the microwave current between the generator and the antenna.

In one embodiment, represented in Figure 1, the second end 20 of the loop antenna 9 is indirectly connected electrically to the outer conductor 21 of the coaxial microwave connector 7 through the wall 2 of the vacuum chamber 1 which is made of a conductive material or (or/and in addition to the conductivity of the wall) has specific conductive means in relation to the loop antenna 9 and the coaxial microwave connector 7. The second end 20 of the loop antenna 9 may be connected electrically to the inner surface 4 of the wall 2 of the vacuum chamber 1.

In another embodiment, represented in figure 7, the coaxial microwave connector 7 is a bilateral coaxial microwave connector 7' and has also means for connecting the first end 19 of the loop antenna 9 on its internal end (inside the vacuum chamber). The outer conductor 21 of the bilateral coaxial microwave connector 7' can comprise a protrusion 22 inside the vacuum chamber 1.

The loop antenna 9 is directly connected to the bilateral coaxial microwave connector 7' through the protrusion 22 of the outer conductor 21 allowing swapping of antenna for whatever reason (notably, for example, change of frequency or radiation pattern).

Other ancillary equipments (for example vacuum pump, gas delivery system, access door, carrier...) have not been represented for simplification purposes.

In the instance of figure 1, the means for generating a static (constant) magnetic field comprises two magnetic dipoles 10. The two magnetic dipoles 10 are located on the two sides of the device 6 for exciting the plasma. The device 6 for exciting the plasma may be at equal distance from the two magnetic dipoles 10 or not at equal distance. The poles of the magnetic dipoles 10 are planar faces, upper surface 11 toward exterior and lower surface 12 toward interior (and wall 2) of the vacuum chamber 1. In Figure 1, the magnetic dipoles 10 are permanent magnets having a quadrilateral shape (magnetic bars), located on the outer surface 3 of the vacuum chamber 1 and partially embedded in said surface. In other embodiments, the magnetic dipoles 10 are not embedded or totally embedded within the wall or are located on the inner surface 4 of the wall (embedded partially or not). Still in Figure 1, each magnetic dipole 10 comprises two magnetic poles N, S which are sensibly perpendicular to the wall 2 as the device 6 for exciting the plasma is and the lines of magnetic field escaping the poles N, S are (for most of them) sensibly parallel to the device 6 for exciting the plasma. It has to be noted that the poles N, S are reversed on the two magnetic dipoles 10. Necessarily, at least in the region in relation to the device(s) 6 for exciting the plasma and means for generating a constant magnetic field, the wall 2 of the vacuum chamber is made of a material which does not impair, distort or attenuate the magnetic field, for example aluminum or non-magnetic stainless steel.

As a consequence, the material which is used for the wall 2 is chosen in order to at least avoid magnetic field perturbation and, if used for electrical connection of the loop antenna 9, to allow electrical conduction as regards at least microwave signal. Preferably, the wall 2 is made of (entirely of partly) a metallic material.

Again, in order to create magnetic field for ECR effect to take place, the coaxial microwave connector 7 mounted on the flange 13 and attached to the wall 2 of vacuum vessel 1 is surrounded by the magnetic dipoles 10, which are in the selected embodiment partially seat in the grooves machined into the wall 2.

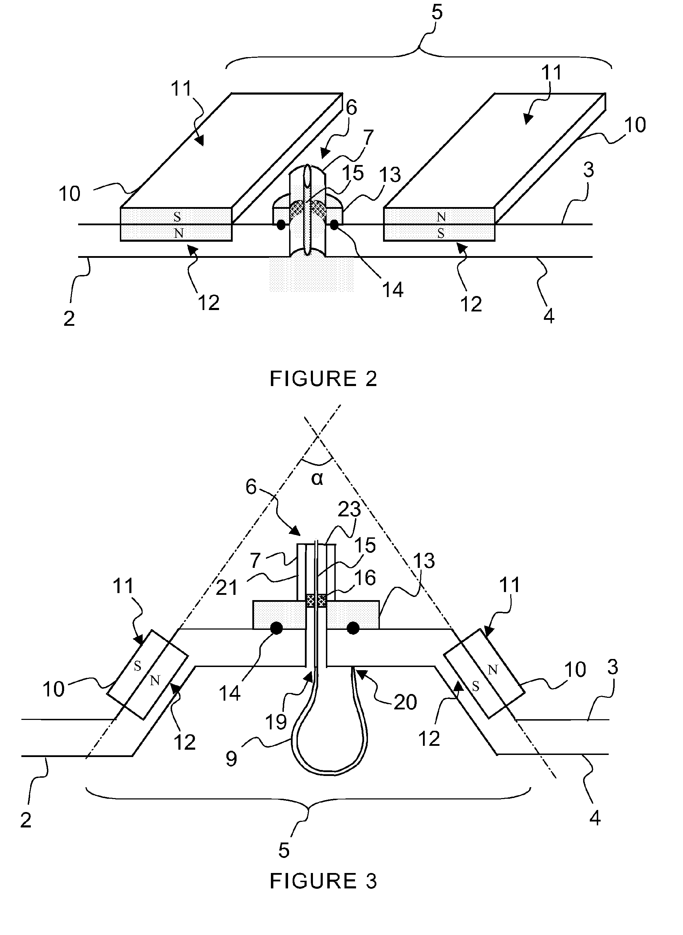

As already seen and represented in Figure 2, the lower surfaces 12 of the magnetic dipoles 10 of the means for generating a constant magnetic field are coplanar.

In another embodiment represented in Figure 3, the magnetic dipoles 10 (magnetic bars) are positioned in inclined parts of the reactor wall 2. In this last instance, the lower surfaces 12 of the two magnetic dipoles 10 of the means for generating a constant magnetic field are inclined with respect to each other and according to an angle (α). Still in Figure 3, the flange 13 with coaxial microwave connector 7 and antenna loop 9 is mounted on a specially shaped part of wall 2 of the vacuum chamber 1. The magnetic dipoles 10 are positioned on inclined angle to the connection plane of the vacuum flange 13.

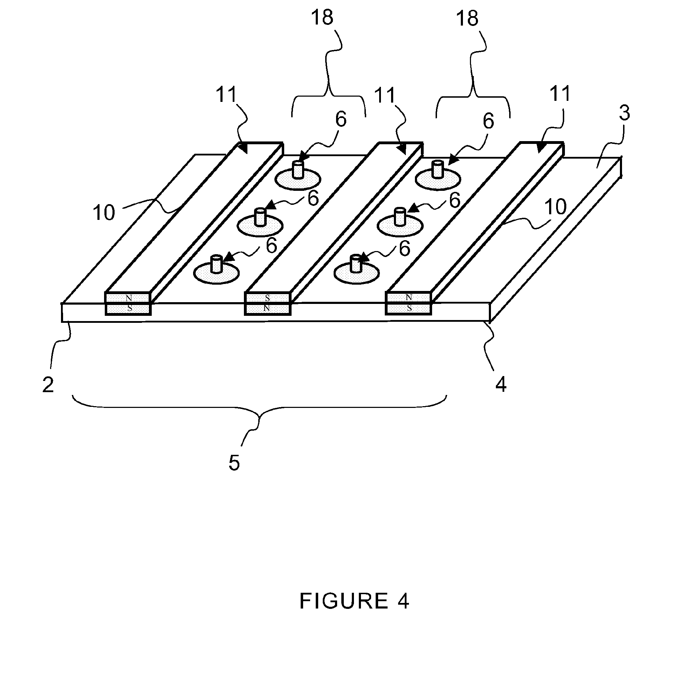

As shown in Figure 4, devices for exciting the plasma 6 (or elementary plasma sources) are easy to arrange in one or two-dimensional arrays in order to create linear plasma source or planar large-area plasma source. Flanges 13 carrying coaxial microwave connector 7 and antenna loops 9 are positioned in lines and are alternated with bars of permanent magnets of alternating polarities. Flanges 13 carrying coaxial microwave connector 7 and antenna loops 9 may be positioned approximately in lines.

The plasma source 5 may comprise n lines 18 of devices for exciting the plasma, n being superior or equal to 1. In this instance, n is equal to two. Each of the two lines 18 of devices for exciting the plasma comprises one or more devices for exciting the plasma 6. In this instance, each of the two lines 18 of devices for exciting the plasma comprises three devices for exciting the plasma 6, forming a matrix of six devices for exciting the plasma 6.

Alternatively, the number of devices for exciting the plasma 6 may be different within the lines 18 of devices for exciting the plasma.

The means for generating a constant magnetic field comprises n+1 magnetic dipoles 10. Each line 18 of devices for exciting the plasma have two magnetic dipoles 10 placed on both sides, forming a one or two-dimensional array of devices for exciting the plasma 6 wherein the n lines 18 of devices for exciting the plasma are alternated with the n+1 magnetic dipoles 10. In this instance, the means for generating a constant magnetic field comprises three magnetic dipoles 10.

For instance, the magnetic dipoles 10 can have a width between 3 and 5 centimeters but it is not limited. The length of the magnetic dipoles 10 is function of the number of devices for exciting the plasma 6. The length of a magnetic dipole 10 associated with only one device for exciting the plasma 6 may be approximately 4 centimeters.

With one or two-dimensional array of devices for exciting the plasma 6, it is thus possible to obtain a large variety of plasma deposition areas.

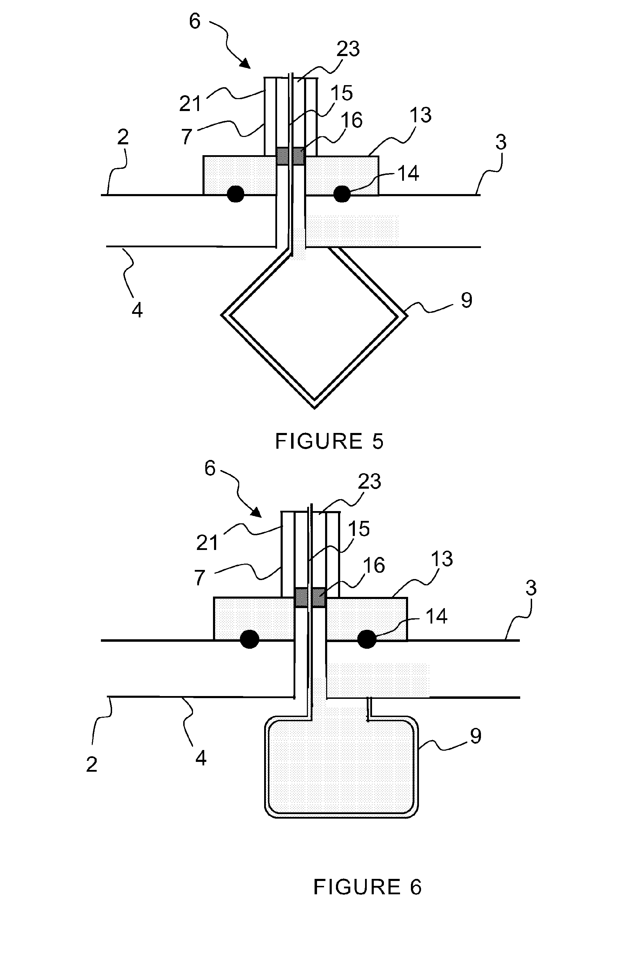

The previous explanations about the invention are not limiting and numerous other embodiments may be manufactured. For example, other shapes of loop antenna 9 may be used as shown in Figures 5 and 6 with a rhombic and a frame loop antenna respectively. The device for exciting the plasma 6 could use a bilateral connector as already described instead of having an integral device (with loop antenna part soldered or welded to the coaxial microwave connector 7 with its flange 13). In addition to the magnetic dipoles 10 (permanent magnets) described in the above examples, other magnetic dipoles 10 can be used to modify the magnetic field configuration and to adjust the global magnetic flux distribution.

## Claims

1. An apparatus for generating a plasma comprising:
- a vacuum chamber (1) comprising a wall (2) having an outer surface (3) and an inner surface (4),
- a plasma source (5) comprising:
o one or more devices for exciting the plasma (6), each of said devices for exciting the plasma (6) comprising a coaxial microwave connector (7) able to be connected to a microwave energy source and a loop antenna (9) able to emit a microwave energy for exciting the plasma,
o means for generating a constant magnetic field around the plasma in order to couple microwave energy into plasma at electron cyclotron resonance,
**characterised in that**:
- the loop antenna (9) of the one or more devices for exciting the plasma (6) is positioned inside the vacuum chamber (1) in order to be in contact with the plasma, and
- the means for generating a constant magnetic field comprises at least two magnetic dipoles (10) placed on the wall of the vacuum chamber (1), each of said one or more devices for exciting the plasma (6) having said two magnetic dipoles (10) placed on both sides.

2. An apparatus for generating a plasma according to claim 1, **characterised in that** the at least two magnetic dipoles (10) are placed on the outer wall surface (3) of the vacuum chamber (1).

3. An apparatus for generating a plasma according to claim 1 or 2, **characterised in that** the at least two magnetic dipoles (10) are permanent magnets having a quadrilateral shape, an upper surface (11) and a lower surface (12), said upper surface (11) being parallel to said lower surface (12), and said lower surface (12) of the at least two permanent magnets being placed on the outer wall surface (3) of the vacuum chamber (1).

4. An apparatus for generating a plasma according to any one of claims 1 to 3, **characterised in that**:
- the plasma source comprises one or more devices for exciting the plasma (6), and
- the means for generating a constant magnetic field comprises only two magnetic dipoles (10) placed on both sides of said one or more devices for exciting the plasma (6).

5. An apparatus for generating a plasma according to any one of claims 1 to 3, **characterised in that**:
- the plasma source comprises n lines (18) of devices for exciting the plasma, n being superior or equal to 1, each of the n lines (18) of devices for exciting the plasma comprising one or more devices for exciting the plasma (6),
- the means for generating a constant magnetic field comprises n+1 magnetic dipoles (10), each lines (18) of devices for exciting the plasma having two magnetic dipoles (10) placed on both sides, forming a one or two-dimensional array of devices for exciting the plasma (6) wherein the n lines (18) of devices for exciting the plasma (6) are alternated with the n+1 magnetic dipoles (10).

6. An apparatus for generating a plasma according to claim 5, **characterised in that** the number of devices for exciting the plasma (6) is modulated in each lines (18) of devices for exciting the plasma.

7. An apparatus for generating a plasma according to any one of claims 4 to 6, **characterised in that** the lower surfaces (12) of the permanent magnets of the means for generating a constant magnetic field are coplanar.

8. An apparatus for generating a plasma according to claim 4, **characterised in that** the lower surfaces (12) of the two permanent magnets of the means for generating a constant magnetic field are inclined with respect to each other, according to an angle (α).

9. An apparatus for generating a plasma according to claim 8, **characterised in that** the wall of the vacuum chamber (2) comprises a shaped part including a first surface whereon the one or more devices for exciting the plasma (6) are placed, and two second surfaces inclined with respect to the first surface, each second surface supporting one of the two permanent magnets and being linked to the first surface.

10. An apparatus for generating a plasma according to any one of claims 1 to 9, **characterised in that** the coaxial microwave connector (7) comprises an outer conductor (21) and the loop antenna (9) comprises a first end (19) and a second end (20), said first end (19) being connected electrically to the central conductor (15) of the coaxial microwave connector (7) and said second end (20) being connected electrically indirectly to the outer conductor (21) of the coaxial microwave connector (7), by grounding on the inner surface (4) of the wall (2) of the vacuum chamber (1).

11. An apparatus for generating a plasma according to any one of claims 1 to 9, **characterised in that** the coaxial microwave connector (7) is a bilateral coaxial microwave connector (7'), the first end (19) of the loop antenna (9) being connected electrically to the central conductor (15) and the second end (20) of the loop antenna (9) being connected electrically directly to the outer conductor (21) of the coaxial microwave connector (7), inside the vacuum chamber (1).

## Amended claims

### Amended claims in accordance with Rule 137(2) EPC.

**1.** An apparatus for generating a plasma comprising:
- a vacuum chamber (1) comprising a wall (2) having an outer surface (3) and an inner surface (4),
- a plasma source (5) comprising:
o one or more devices for exciting the plasma (6), each of said devices for exciting the plasma (6) comprising a coaxial microwave connector (7) able to be connected to a microwave energy source and a loop antenna (9) able to emit a microwave energy for exciting the plasma,
o means for generating a constant magnetic field around the plasma in order to couple microwave energy into plasma at electron cyclotron resonance,
**characterised in that**:
- the coaxial microwave connector (7) of the device for exciting the plasma (6) is connected to the loop antenna (9) on one side, and is able to be directly connected to the microwave energy source via a coaxial line on the other side,
- the loop antenna (9) of the one or more devices for exciting the plasma (6) is positioned inside the vacuum chamber (1) in order to be in contact with the plasma, and
- the means for generating a constant magnetic field comprises at least two magnetic dipoles (10) placed on the outer wall surface (3) of the vacuum chamber (1), each of said one or more devices for exciting the plasma (6) having said two magnetic dipoles (10) placed on both sides.

**2.** An apparatus for generating a plasma according to claim 1, **characterised in that** the at least two magnetic dipoles (10) are permanent magnets having a quadrilateral shape, an upper surface (11) and a lower surface (12), said upper surface (11) being parallel to said lower surface (12), and said lower surface (12) of the at least two permanent magnets being placed on the outer wall surface (3) of the vacuum chamber (1).

**3.** An apparatus for generating a plasma according to any one of claims 1 to 2, **characterised in that**:
- the plasma source comprises one or more devices for exciting the plasma (6), and
- the means for generating a constant magnetic field comprises only two magnetic dipoles (10) placed on both sides of said one or more devices for exciting the plasma (6).

**4.** An apparatus for generating a plasma according to any one of claims 1 to 2, **characterised in that**:
- the plasma source comprises n lines (18) of devices for exciting the plasma, n being superior or equal to 1, each of the n lines (18) of devices for exciting the plasma comprising one or more devices for exciting the plasma (6),
- the means for generating a constant magnetic field comprises n+1 magnetic dipoles (10), each lines (18) of devices for exciting the plasma having two magnetic dipoles (10) placed on both sides, forming a one or two-dimensional array of devices for exciting the plasma (6) wherein the n lines (18) of devices for exciting the plasma (6) are alternated with the n+1 magnetic dipoles (10).

**5.** An apparatus for generating a plasma according to claim 4, **characterised in that** the number of devices for exciting the plasma (6) is modulated in each lines (18) of devices for exciting the plasma.

**6.** An apparatus for generating a plasma according to any one of claims 3 to 5, **characterised in that** the lower surfaces (12) of the permanent magnets of the means for generating a constant magnetic field are coplanar.

**7.** An apparatus for generating a plasma according to claim 3, **characterised in that** the lower surfaces (12) of the two permanent magnets of the means for generating a constant magnetic field are inclined with respect to each other, according to an angle (α).

**8.** An apparatus for generating a plasma according to claim 7, **characterised in that** the wall of the vacuum chamber (2) comprises a shaped part including a first surface whereon the one or more devices for exciting the plasma (6) are placed, and two second surfaces inclined with respect to the first surface, each second surface supporting one of the two permanent magnets and being linked to the first surface.

**9.** An apparatus for generating a plasma according to any one of claims 1 to 8, **characterised in that** the coaxial microwave connector (7) comprises an outer conductor (21) and the loop antenna (9) comprises a first end (19) and a second end (20), said first end (19) being connected electrically to the central conductor (15) of the coaxial microwave connector (7) and said second end (20) being connected electrically indirectly to the outer conductor (21) of the coaxial microwave connector (7), by grounding on the inner surface (4) of the wall (2) of the vacuum chamber (1).

**10.** An apparatus for generating a plasma according to any one of claims 1 to 8, **characterised in that** the coaxial microwave connector (7) is a bilateral coaxial microwave connector (7'), the first end (19) of the loop antenna (9) being connected electrically to the central conductor (15) and the second end (20) of the loop antenna (9) being connected electrically directly to the outer conductor (21) of the coaxial microwave connector (7), inside the vacuum chamber (1).
